# EUROPEAN PATENT APPLICATION

(11) **EP 4 679 943 A1**
(43) Date of publication of application: **14.01.2026**
(21) Application number: 24770539.5
(22) Date of filing: 28.02.2024
(51) Int. Cl.: H05K 1/03, C08J 5/00, C08K 3/01, C08K 3/08, C08K 3/22, C08L 53/02, C08L 71/12, H01Q 1/38, H05K 3/10

(54) **THERMOPLASTIC RESIN COMPOSITION, MOLDED ARTICLE AND COMMUNICATION DEVICE COMPONENT**

(30) Priority: 10.03.2023 JP 2023038116; 23.06.2023 JP 2023103666
(71) Applicant: Asahi Kasei Kabushiki Kaisha, Tokyo 1000006 (JP)
(72) Inventor: TOKUYAMA, Miki, Tokyo 100-0006 (JP); KURAMITSU, Masahito, Tokyo 100-0006 (JP); TESHIMA, Yuta, Tokyo 100-0006 (JP)
(74) Representative: Strehl & Partner mbB
(86) International application number: PCT/JP2024/007423
(87) International publication number: WO 2024/190428

(57) **Abstract**

The present disclosure is directed to providing a thermoplastic resin composition that serves as a material for a component for a telecommunication apparatus with excellent performance as an antenna and that exhibits excellent antenna performance regardless of injection molding conditions, particularly when injection molding is performed at high temperatures. The present disclosure contains a polyphenylene ether-based resin and a laser direct structuring additive (LDS additive), wherein the inter-particle distance of the LDS additive is 2.2 to 3.2 ¡..tm, the Vicat softening temperature is 90 °C or higher, and the water absorption rate is 1.5% or less.

## Description

### TECHNICAL FIELD

The present disclosure relates to a component for a telecommunication apparatus. Specifically, it relates to a molded article made from a thermoplastic resin composition containing a laser direct structuring additive and a component for a telecommunication apparatus having a conductive portion on a surface of the molded article.

### BACKGROUND

In recent years, with reductions in the weights and sizes of cell phones and other mobile communication apparatuses, there has been a growing demand for lighter and smaller parts used for communication apparatuses such as dielectric antennas. Thus, there has been a demand for methods of manufacturing antennas that can be three-dimensionally designed for smartphones, wireless earphones, personal computers, etc.

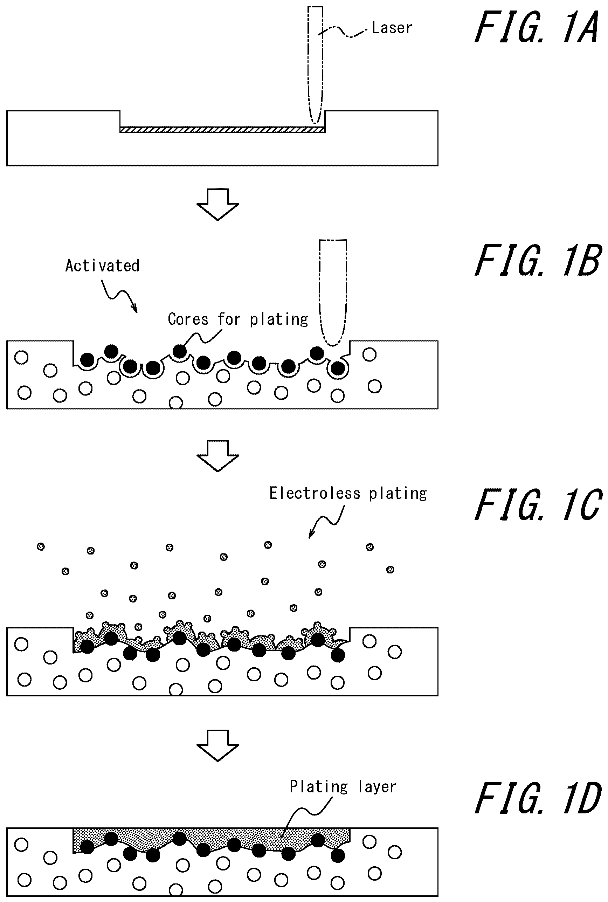

One of the technologies for forming such a three-dimensional antenna is laser direct structuring (hereinafter sometimes referred to as "LDS"), which is gaining attention. LDS technology involves irradiating a surface of a molded product made from a thermoplastic resin composition adapted for LDS containing an LDS additive with a laser (FIG. 1(a)) to activate only the laser-irradiated portion (FIG. 1(b)) and applying a metal to the activated portion (FIG. 1(c)) to form a conductive portion (plating layer, etc.) (FIG. 1(d)). This technology is characterized in that it allows the manufacturing of metal structures such as antennas directly on a surface of a resin substrate without using adhesives, enabling the miniaturization of components.

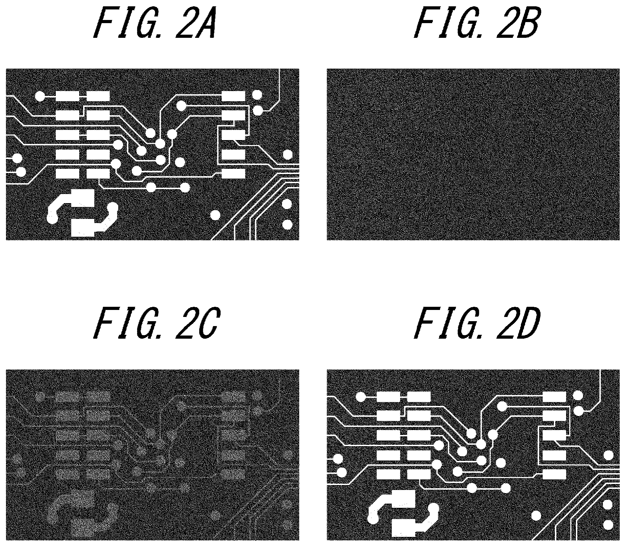

Here, FIG. 2 illustrates the flow of mounting a circuit using LDS technology. After the circuit (FIG. 2(a)) is designed, a molded article of a resin is provided (FIG. 2(b)). The laser is irradiated along the shape of the designed circuit (FIG. 2(c)). Plating is then applied to obtain a metal structure of the desired shape (FIG. 2(d)).

Such a LDS technology is disclosed, for example, in PTL 1-3. LDS is one of the 3D-MID technologies, and examples of components using the technology include antennas for smartphones, antennas for wearable devices, and antennas for automotive applications, as disclosed in NPL 1. Furthermore, photographs of antenna examples are disclosed in NPL 2.

### CITATION LIST

PTL 1: JP 2000-503817 A
PTL 2: JP 2004-534408 A
PTL3: WO2009/141800 A1
NPL 1: Hiroyuki Uedate, MID Production by LPKF-LDS® Process, Journal of the Surface Finishing Society of Japan, 2020, Vol. 71, No. 4, pp. 268-272 NPL 2: Toshiki Arano, MID: Potential Application of Manufacturing Technology for Metal-Plastic Complex Structure, Transactions of The Japan Institute of Electronics Packaging, 2017, Vol. 20, No. 6, pp. 268-272

### SUMMARY

### (Technical Problem)

Components for telecommunication apparatuses made from thermoplastic resin compositions adapted for LDS as described above are required to have electrical properties and good fluidity. In recent years, antennas have become essential to exhibit characteristics in high-frequency bands of 1 GHz or higher, and they are required to have low dielectric properties for this purpose. Furthermore, as mentioned above, the communication apparatuses *per se* are trending toward being lightweight and compact, and the components used in these communication apparatuses are also being miniaturized to meet these demands. Such small components must have thinner shapes.

Generally, when small molded products with thin parts are molded, the molding temperature is set high. However, when conventional thermoplastic resin compositions adapted for LDS are molded at high temperatures, the resulting molded articles sometimes do not exhibit sufficient dielectric properties. As a result, their performances as antennas may not be sufficient.

Thus, an object of the present disclosure is to provide a thermoplastic resin composition, molded article, and component for a telecommunication apparatus that can achieve excellent antenna performance regardless of the molding conditions even when molding is performed at high temperatures.

### (Solution to Problem)

The present inventors have intensively studied to solve the above-mentioned problem and have discovered that excellent antenna performance can be achieved regardless of the molding conditions by setting the LDS additive included in the thermoplastic resin composition constituting the component for a telecommunication apparatus to a certain dispersion state, leading to the completion of the present disclosure.

Specifically, the present disclosure is as follows.
[1] A thermoplastic resin composition comprising:
   a polyphenylene ether-based resin and a laser direct structuring additive (LDS additive),
   wherein an inter-particle distance of the LDS additive is 2.2 to 3.2 µm, and
   the thermoplastic resin composition has a Vicat softening temperature of 90 °C or higher and a water absorption rate of 1.5% or less.
[2] A molded article made from a thermoplastic resin composition and comprising a conductive portion formed on a surface thereof,
   wherein the thermoplastic resin composition comprises a polyphenylene ether-based resin and a laser direct structuring additive (LDS additive),
   an inter-particle distance of the LDS additive in the thermoplastic resin composition is 2.2 to 3.2 µm, and
   the thermoplastic resin composition has a Vicat softening temperature of 90 °C or higher and a water absorption rate of 1.5% or less.
[3] The molded article according to [2], wherein the conductive portion is formed by laser direct structuring.
[4] A component for a telecommunication apparatus comprising the molded article according to [2] or [3].
[5] The component for a telecommunication apparatus according to [4], wherein the LDS additive is a compound containing antimony and tin.
[6] The component for a telecommunication apparatus according to [4], wherein the LDS additive presents in 220 particles or fewer in one field of view (62.02 µm × 39.77 µm) when the thermoplastic resin composition is observed under a microscope.
[7] The component for a telecommunication apparatus according to [4], wherein a maximum particle diameter of the LDS additive is 2.2 µm or more.
[8] The component for a telecommunication apparatus according to [4], wherein a content of a copper chromate compound as the LDS additive is less than 5 parts by mass per 100 parts by mass of the thermoplastic resin composition.
[9] The component for a telecommunication apparatus according to [4], wherein a content of the LDS additive is 3 parts by mass or more and less than 20 parts by mass per 100 parts by mass of the thermoplastic resin composition.
[10] The component for a telecommunication apparatus according to [4], wherein the thermoplastic resin composition contains a block copolymer containing at least one block mainly composed of an aromatic vinyl monomer unit and at least one block mainly composed of a conjugated diene monomer unit, and/or a hydrogenated product of the block copolymer.
[11] The component for a telecommunication apparatus according to [4], wherein the thermoplastic resin composition has a deflection temperature under load (DTUL) of 90 °C or higher.
[12] The component for a telecommunication apparatus according to [4], wherein the thermoplastic resin composition has a dielectric constant of 3.0 or less and a dielectric loss tangent of 0.008 or less.
[13] The component for a telecommunication apparatus according to [4], wherein the dielectric loss tangent after the thermoplastic resin composition is immersed in warm water at 80 °C for 144 hours is 0.03 or less.
[14] The component for a telecommunication apparatus according to [4], being a component for an antenna.

### (Advantageous Effect)

According to the present disclosure, it is possible to provide a thermoplastic resin composition, molded article, and component for a telecommunication apparatus that can achieve excellent antenna performance regardless of the molding conditions even when molding is performed at high temperatures.

### BRIEF DESCRIPTION OF THE DRAWINGS

FIG. 1 is a diagram illustrating the flow of applying plating using laser direct structuring technology;
FIG. 2 is a diagram illustrating the flow of applying plating to a resin molded article to form a circuit using laser direct structuring technology; and
FIG. 3 is a diagram illustrating the antenna used for evaluating the antenna performance when molding was performed at a high temperature in the examples.

### DETAILED DESCRIPTION

The following provides a detailed description of the present disclosure.

A component for a telecommunication apparatus of the present embodiment includes a molded article made from a thermoplastic resin composition and a conductive portion formed on a surface of the molded article.

### [Thermoplastic resin composition and molded article]

The thermoplastic resin composition constituting the molded article of the present embodiment includes (A) a matrix resin and (B) an LDS additive.

It is preferable that the (A) matrix resin contains (A-a) a polyphenylene ether-based resin and may optionally contain (A-b) a block copolymer containing at least one block mainly composed of an aromatic vinyl monomer unit and at least one block mainly composed of a conjugated diene monomer unit, and/or a hydrogenated product of the block copolymer.

### ((A) Matrix resin)

The (A) matrix resin refers to a resin component excluding an inorganic filler, etc. The (B) LDS additive mentioned later is excluded from the (A) matrix resin. Such resin components include at least a polyphenylene ether-based resin, and may also include various other resins used for molding, such as polyester-based resins, polyamide-based resins, polycarbonate-based resins, vinyl-based resins, olefinic resins, acrylic resins, polyphenylene sulfide, aromatic resins, etc.

### - (A-a) Polyphenylene ether-based resin

Specific examples of the (A-a) polyphenylene ether-based resin (hereinafter sometimes simply referred to as "(A-a) component") include poly(2,6-dimethyl-1,4-phenylene ether), poly(2-methyl-6-ethyl-1,4-phenylene ether), poly(2-methyl-6-phenyl-1,4-phenylene ether), and poly(2,6-dichloro-1,4-phenylene ether), for example. Furthermore, polyphenylene ether copolymers, such as copolymers of 2,6-dimethylphenol and other phenols (e.g., copolymers with 2,3,6-trimethylphenol or copolymers with 2-methyl-6-butylphenol, as described in JP S52-17880 B), can also be used.

Among these, polyphenylene ethers such as poly(2,6-dimethyl-1,4-phenylene ether), a copolymer of 2,6-dimethylphenol and 2,3,6-trimethylphenol, or a mixture of these are particularly preferred as polyphenylene ether.

The (A-a) component may, for example, be a homopolymer composed of a repeating unit structure represented by the following formula (1) or a copolymer including a repeating unit structure represented by the following formula (1).

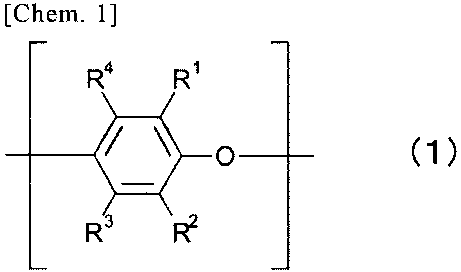

In the above formula (1), R¹, R², R³, and R⁴ are each independently monovalent groups selected from the group consisting of hydrogen atom, halogen atom, primary alkyl groups having 1 to 7 carbon atoms, secondary alkyl groups having 1 to 7 carbon atoms, phenyl group, haloalkyl groups, aminoalkyl groups, hydrocarbon oxy groups, and halohydrocarbon oxy groups in which at least two carbon atoms separate a halogen atom from an oxygen atom.

The (A-a) component may be used alone or in combination with two or more types.

The (A-a) polyphenylene ether-based resin can be produced by a commonly known method without any specific limitations. For example, it can be produced by a method described in US 3306874 A in which production is performed through oxidative polymerization of 2,6-xylenol using a complex of a cuprous salt and an amine as a catalyst, for example, or a production method described in any of US 3306875 A, US 3257357 A, US 3257358 A, JP S50-51197 A, JP S52-17880 B, and JP S63-152628 B.

The range of the reduced viscosity (measured with 0.5-g/dL chloroform solution at 30 °C using an Ubbelohde-type viscometer) of the (A-a) polyphenylene ether-based resin is preferably 0.30 to 0.80 dL/g, more preferably 0.35 to 0.75 dL/g, and most preferably 0.38 to 0.55 dL/g. When the reduced viscosity of the (A-a) polyphenylene ether-based resin is within the above range, excellent properties such as impact resistance and heat resistance can be obtained.

Note that a blend of two or more polyphenylene ether-based resins having different reduced viscosities can also preferably be used in the (A-a) polyphenylene ether-based resin.

Further, various known stabilizers can also be preferably used to stabilize the (A-a) polyphenylene ether-based resin. Examples of the stabilizers include metal-based stabilizers such as zinc oxide and zinc sulfide, and organic stabilizers such as hindered phenol-based stabilizers, phosphorus-based stabilizers, and hindered amine-based stabilizers.

The preferred content of such a stabilizer is less than 5 parts by mass per 100 parts by mass of the (A-a) polyphenylene ether-based resin.

Furthermore, a known additive or the like, which can be added to the (A-a) polyphenylene ether-based resin, may also be added in an amount of less than 10 parts by mass per 100 parts by mass of the (A-a) polyphenylene ether-based resin.

The (A-a) component may be a modified polyphenylene ether that is obtained by reacting a styrene-based monomer or derivative thereof and/or an α,β-unsaturated carboxylic acid or derivative thereof with the homopolymer and/or copolymer described above.

Here, the grafted amount or added amount of the styrene monomer or derivative thereof and/or α,β-unsaturated carboxylic acid or derivative thereof is preferably 0.01 to 10 mass% per 100 mass% of the (A-a) component.

The method by which the modified polyphenylene ether is produced may, for example, be a method in which a reaction is carried out under a temperature of 80 to 350 °C in a molten state, solution state, or slurry state, and in the presence or absence of a radical precursor.

The polyphenylene ether that is used may be a mixture of the homopolymer and/or copolymer described above and the modified polyphenylene ether described above in any ratio.

From the viewpoint of achieving both heat resistance and low dielectric constant and low dielectric loss tangent, the content of the (A-a) polyphenylene ether-based resin per 100 parts by mass of the (A) matrix resin is preferably 30 parts by mass or more, more preferably 40 parts by mass or more, and even more preferably 50 parts by mass or more. From the viewpoint of moldability, it is preferably 95 parts by mass or less.

- (A-b) Block copolymer containing at least one block mainly composed of aromatic vinyl monomer unit and at least one block mainly composed of conjugated diene monomer unit, and/or hydrogenated product of the block copolymer

In the present embodiment, (A-b) a block copolymer containing at least one block mainly composed of an aromatic vinyl monomer unit and at least one block mainly composed of a conjugated diene monomer unit, and/or a hydrogenated product of the block copolymer (hereinafter, simply referred to as "(A-b) component") may be further included, and is preferably included. The (A-b) block copolymer containing at least one block mainly composed of an aromatic vinyl monomer unit and at least one block mainly composed of a conjugated diene monomer unit, and/or a hydrogenated product of the block copolymer refers to a non-hydrogenated block copolymer containing at least one aromatic vinyl polymer block mainly composed of an aromatic vinyl monomer unit and at least one conjugated diene polymer block mainly composed of a conjugated diene monomer unit, and/or a hydrogenated product of the block copolymer.

Note that "mainly composed of an aromatic vinyl monomer unit" in relation to the aromatic vinyl polymer block means that aromatic vinyl monomer units constitute 50 mass% or more of the block. Aromatic vinyl monomer units more preferably constitute 70 mass% or more, even more preferably 80 mass% or more, and most preferably 90 mass% or more.

Likewise, "mainly composed of a conjugated diene monomer unit" in relation to the conjugated diene polymer block means that conjugated diene monomer units constitute 50 mass% or more of the block. Conjugated diene monomer units more preferably constitute 70 mass% or more, even more preferably 80 mass% or more, and most preferably 90 mass% or more.

Moreover, the aromatic vinyl polymer block may, for example, be a copolymer block having a small amount of a conjugated diene compound bonded at random in the aromatic vinyl polymer block. Likewise, the conjugated diene polymer block may, for example, be a copolymer block having a small amount of an aromatic vinyl compound bonded at random in the conjugated diene polymer block.

Examples of aromatic vinyl compounds that may be used to form aromatic vinyl monomer units include, but are not specifically limited to, styrene, α-methylstyrene, and vinyltoluene. One or more compounds selected from these may be used, of which, styrene is particularly preferable.

Examples of conjugated diene compounds that may be used to form the conjugated diene polymer block include, but are not specifically limited to, butadiene, isoprene, piperylene, and 1,3-pentadiene. One or more compounds selected from these may be used, of which, butadiene, isoprene, and combinations thereof are preferable.

The microstructure of the conjugated diene polymer block moiety of the block copolymer has a 1,2-vinyl content or a sum of the 1,2-vinyl content and the 3,4-vinyl content (total vinyl bond content) of preferably 5 to 80%, more preferably 10 to 70%.

Note that the total vinyl bond content can be measured using an infrared spectrophotometer.

The non-hydrogenated block copolymer used in the production of a hydrogenated product of the block copolymer (hydrogenated block copolymer) is preferably a block copolymer having a bonding form of the aromatic vinyl polymer block (A) and the conjugated diene polymer block (B) selected from an A-B type, an A-B-A type, and an A-B-A-B type. Of these, a combination of block copolymers having different bonding structures among those listed above may be used.

Among these, possession of a bonding form selected from A-B-A and A-B-A-B types is more preferred, and a bonding form having an A-B-A type is even more preferred.

Furthermore, the (A-b) component used in the present embodiment is preferably a partially hydrogenated block copolymer (partially hydrogenated block copolymer).

The term "partially hydrogenated block copolymer" means that the non-hydrogenated block copolymer described above has been subjected to hydrogenation treatment so as to control aliphatic double bonds in the conjugated diene polymer block to within a range of more than 0% and less than 100%. The preferred hydrogenation percentage of the partially hydrogenated block copolymer is 50% or more and less than 100%, preferably 80% or more and less than 100%, and most preferably 98% or more and less than 100%.

Furthermore, the (A-b) component preferably has a number average molecular weight of 30,000 or more and less than 300,000. When it is in the above range, a composition having excellent fluidity, impact strength, and flame retardance can be obtained.

The evaluation method for the number average molecular weight of the (A-b) component in the resin composition will be described below.

Specifically, the (A-b) component is isolated using a solvent that has good solubility for the (A-b) component but has poor solubility for the (A-a) polyphenylene ether-based resin, such as chloroform, for example. The isolated component is then measured using a gel permeation chromatography measurement device (GPC SYSTEM21 manufactured by Showa Denko K.K.) and a UV spectroscopic detector (UV-41 manufactured by Showa Denko K.K.) so as to determine the number average molecular weight thereof as a standard polystyrene-equivalent value.

Note that the measurement conditions may be as follows: solvent: chloroform temperature: 40 °C, column: K-G, K-800RL, and K-800R at sample side and K-805L × 2 at reference side, flow rate: 10 mL/min, measurement wavelength: 254 nm, and pressure: 15 to 17 kg/cm².

Also note that low molecular weight components resulting from catalyst deactivation during polymerization may be detected during measurement of the number average molecular weight, but these low molecular weight components are excluded from molecular weight calculation. The term "low molecular weight components" refers to components having a molecular weight of 3,000 or less. In general, the correct calculated molecular weight distribution (weight average molecular weight/number average molecular weight) is within a range of 1.0 to 1.1.

These block copolymers as the (A-b) component that can be used in the present embodiment may be, unless otherwise contrary to the purpose of the present embodiment, a mixture of two or more of those with different bonding forms, those with different aromatic vinyl compound types, those with different conjugated diene compound types, those with different 1,2-bond vinyl content or 1,2-bond vinyl content and 3,4-bond vinyl content, those with different content of aromatic vinyl compounds, and those with different hydrogenation rates.

These block copolymers as the (A-b) component that can be used in the present embodiment can also be block copolymers that have been modified entirely or partially.

The term "modified block copolymer" refers to a block copolymer that has been modified with at least one modifying compound having, in its molecular structure, at least one carbon-carbon double or triple bond and at least one carboxylic acid group, acid anhydride group, amino group, hydroxyl group, or glycidyl group.

The method by which the modified block copolymer is produced may be a method in which, in the presence or absence of a radical initiator, (1) the block copolymer is melt-kneaded and reacted with a modifying compound in a temperature range of not lower than the softening point of the block copolymer and not higher than 250 °C, (2) the block copolymer and a modifying compound are reacted in solution at a temperature that is not higher than the softening point of the block copolymer, or (3) the block copolymer and a modifying compound are reacted without melting at a temperature that is not higher than the softening point of the block copolymer. Although any of these methods may be used, the method (1) is preferable, and the method (1) performed in the presence of a radical initiator is most preferable.

Note that the "at least one modifying compound having, in its molecular structure, at least one carbon-carbon double or triple bond and at least one carboxylic acid group, acid anhydride group, amino group, hydroxyl group, or glycidyl group" can be the same as the modified compounds described for modified polyphenylene ether.

Additionally, the content of the (A-b) component is preferably 1 to 40 parts by mass, more preferably 2 to 35 parts by mass, and even more preferably 2 to 30 parts by mass, when the amount of the (A-a) polyphenylene ether-based resin is considered 100 parts by mass.

Furthermore, the total content of the (A-a) polyphenylene ether-based resin and the (A-b) component per 100 parts by mass of the (A) matrix resin is preferably 30 parts by mass or more, and more preferably 35 parts by mass or more. By setting the total content of the (A-a) component and the (A-b) component within the above range, it is possible to achieve both heat resistance and low dielectric constant and low dielectric loss tangent and to ensure that the (B) LDS additive mentioned later can be dispersed in any desired state.

### - (A-c) Polystyrene-based resin

The (A) matrix resin may include a polystyrene-based resin. Examples of the polystyrene-based resin include an atactic polystyrene, a rubber-reinforced polystyrene (high impact polystyrene, HIPS), a styrene-acrylonitrile copolymer (SAN) having a styrene content of 50 weight % or more, and an ABS resin in which such a styrene-acrylonitrile copolymer is reinforced with a rubber. Of these, ones containing the atactic polystyrene and/or high impact polystyrene are preferred.

Note that the polystyrene-based resins may be used alone or in combination with two or more types.

The preferred content of the (A-c) polystyrene-based resin in the present embodiment is 0 to 100 parts by mass, more preferably 0 to 90 parts by mass, and even more preferably 0 to 80 parts by mass when the content of the (A-a) polyphenylene ether-based resin is considered 100 parts by mass.

### - Other resin components

Examples of other resin components in the (A) matrix resin of the present embodiment include polyester, polyolefin such as polypropylene, polyamide, polyphenylene sulfide, and olefinic thermoplastic elastomers.

Examples of the olefinic thermoplastic elastomers include polyolefin homopolymers such as polyethylene and polypropylene; and polyolefin copolymers such as ethylene-propylene copolymer, ethylene-butylene copolymer, and ethylene-octene copolymer. In particular, high-pressure low-density polyethylene (LDPE), linear low-density polyethylene (LLDPE), and high-density polyethylene (HDPE) are examples of polyethylene homopolymers.

The specific amount of each of these resin components added is preferably 15 mass% or less, more preferably 13 mass% or less, and even more preferably 10 mass% or less when the entire thermoplastic resin composition is considered 100 mass%.

The amount of other resin components added in total is preferably 30 mass% or less, more preferably 25 mass%, and even more preferably 20 mass% or less when the entire thermoplastic resin composition is considered 100 mass%.

In particular, from the viewpoint of achieving low dielectric loss tangent and low dielectric constant, the sum of the contents of polyamide and polyphenylene sulfide per 100 parts by mass of the (A) matrix resin is preferably 10 parts by mass or less, more preferably 5 parts by mass or less, even more preferably 1 part by mass or less, and may be 0 parts by mass.

### ((B) LDS additive)

The thermoplastic resin composition constituting the molded article of the component for a telecommunication apparatus of the present embodiment further includes (B) a laser direct structuring additive (LDS additive), in addition to the above-mentioned (A) matrix resin.

The inclusion of the LDS additive allows the formation of plating on a surface of the resulting resin molded product using LDS technology to enable the formation of a conductive portion on the surface. In this case, as the dielectric constant and dielectric loss tangent of the thermoplastic resin composition having the conductive portion formed thereon decrease, the antenna characteristics improve.

Additionally, from a practical standpoint, good plating deposition properties for forming the conductive portion and good adhesion of the deposited plating are required. To satisfy these requirements, appropriate thermoplastic resin and LDS additive need to be selected.

The LDS technology is a technique in which a near-infrared pulse laser with a wavelength of 1064 nm or the like is irradiated onto a resin molded product with an output of 7 W at a frequency of 50 kHz and a speed of 2000 mm/s, followed by immersion in an electroless plating bath as a plating process, to selectively form plating only on the laser-irradiated portions.

The (B) LDS additive refers to a compound that allows for the formation of a conductive portion on the surface of the molded article using the LDS technology when added in a certain amount (about 3 to 15 parts by mass per 100 parts by mass of the entire thermoplastic resin composition).

From the viewpoint of enhancing platability, the (B) LDS additive preferably contains at least one of copper, antimony, tin, aluminum, and zinc, more preferably contains a copper chromate compound and/or an oxide containing antimony and tin, and even more preferably contains an oxide containing at least antimony and tin.

More specifically, an embodiment of the (B) LDS additive is an oxide containing at least one of antimony and phosphorus as well as tin, preferably an oxide containing antimony and tin. This is because compounds containing antimony and tin are easier to control the dispersion than the copper chromate compound, resulting in more stable values of dielectric constant and dielectric loss tangent.

Furthermore, the oxide containing antimony and tin is more preferably an oxide in which the content of tin is higher than the content of antimony, and even more preferably an oxide in which the amount of tin is 80 mass% or more of the total amount of tin and antimony.

More specifically, examples of the (B) LDS additive include tin oxide doped with antimony, tin oxide doped with antimony oxide, tin oxide doped with phosphorus, and tin oxide doped with an oxide of phosphorus. Tin oxide doped with antimony and tin oxide doped with antimony oxide is preferred, and tin oxide doped with antimony oxide is more preferred.

Synthetic products or commercially available products may be used as the (B) LDS additive. Additionally, commercially available products may include those commercially available for other purposes as long as they meet the requirements of the LDS additive in the present embodiment, in addition to those commercially available as LDS additives.

The (B) LDS additive may be used alone or in combination with two or more types.

The (B) LDS additive may also contain trace amounts of another metal in addition to antimony and tin. Examples of the other metal includes copper, chromium, lead, indium, iron, cobalt, nickel, zinc, cadmium, silver, bismuth, arsenic, manganese, magnesium, and calcium. These metals may also be present as oxides.

The content of metal oxides other than antimony and tin is preferably 30 mass% or less, and particularly, the content of copper chromate is preferably less than 5 parts by mass (the content is 5 parts by mass or more) per 100 parts by mass of the thermoplastic resin composition.

Furthermore, the content of the (B) LDS additive in the thermoplastic resin composition is preferably 1.0 parts by mass or more, more preferably 2.0 parts by mass or more, even more preferably 3.0 parts by mass or more, further preferably 5.0 parts by mass or more, and even further preferably 6.0 parts by mass or more, per 100 parts by mass of the total thermoplastic resin. By setting the content of the (B) LDS additive to 1.0 parts by mass or more, the platability tends to improve. Additionally, the content of the (B) LDS additive in the thermoplastic resin composition is preferably 30.0 parts by mass or less, more preferably 25.0 parts by mass or less, even more preferably 20.0 parts by mass or less, further preferably 15.0 parts by mass or less, and even further preferably 12.0 parts by mass or less, per 100 parts by mass of the thermoplastic resin. By setting the content of the (B) LDS additive to 30.0 parts by mass or less, the resin composition tends to exhibit a lower dielectric constant and lower dielectric loss tangent.

The thermoplastic resin composition may contain only one type of (B) LDS additive, or may contain two or more types. When two or more types are contained, the total amount preferably falls within the above range.

### ((f) Flame retardant)

The thermoplastic resin composition may further include (f) a flame retardant.

The (f) flame retardant may by an inorganic flame retardant such as magnesium hydroxide or aluminum hydroxide; a nitrogen-containing cyclic compound such as melamine, cyanuric acid, and salts of thereof; an organophosphoric acid ester such as triphenyl phosphate, triphenyl phosphate hydroxide, bisphenol A bis(diphenyl phosphate), and derivative thereof; a phosphoric acid-based nitrogen-containing compound such as ammonium polyphosphate or melamine polyphosphate; a phosphazene-based compound described in JP H11-181429 A; a boric acid compound such as zinc borate; silicone oils; red phosphorus; phosphinates described in WO 2007/055147 A1; mixtures of any of the preceding materials; or the like. Of these, nitrogen-containing cyclic compounds, organophosphoric acid esters, phosphoric acid-based nitrogen-containing compounds, phosphazene-based compounds, boric acid compounds, silicone oils, and phosphinates are preferable, and bisphenol A bis(diphenyl phosphate) and derivatives thereof, phosphinates, and mixtures of any thereof are more preferable.

Examples of the phosphoric acid ester as the flame retardant (f) include those represented by the following formula (I) or (II).

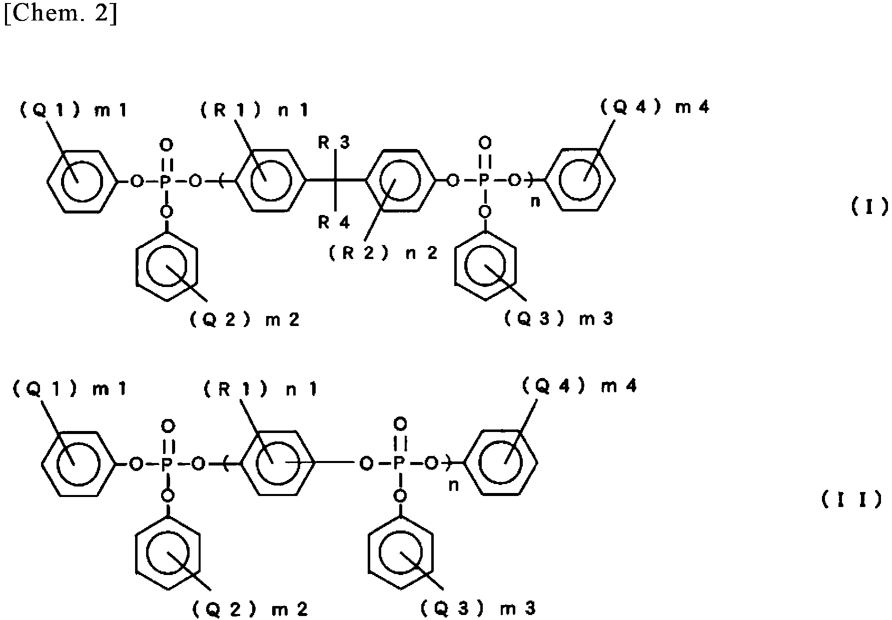

In the above formulae, Q1, Q2, Q3, and Q4 represent an alkyl group with 1 to 6 carbon atoms or hydrogen, and R1, R2, R3, and R4 represent a methyl group or hydrogen. n represents an integer of 1 or more, n1 and n2 represent integers from 0 to 2, and m1, m2, m3, and m4 represent integers from 1 to 3.

The condensed phosphoric acid ester represented by formula (II) has a smaller dipole moment compared to the condensed phosphoric acid ester represented by formula (I), which results in superior dielectric properties.

Among these, from the viewpoint of dipole moment, the preferred condensed phosphoric acid ester is one that contains 50% or more of a phosphoric acid ester where Q1, Q2, Q3, and Q4 are hydrogen or a methyl group, R1 is hydrogen, and n is in the range of 1 to 3 in formula (II), with n being 1 particularly preferred.

The flame retardant is generally commercially available, examples of which include products such as CR-741, CR-747, CR-733S, and PX-200 available from Daihachi Chemical Industry Co., Ltd.

The phosphinates include at least one selected from the group consisting of phosphinates represented by formula (1) below, diphosphinates represented by formula (2) below, and condensates thereof.

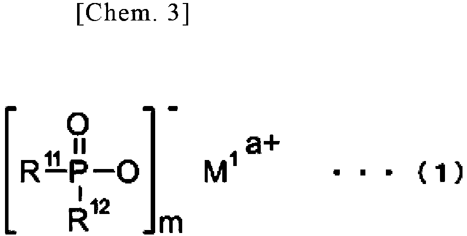

In the above formula (1), R11 and R12 each independently represent a linear or branched alkyl group with 1 to 6 carbon atoms, aryl group, or phenyl group; M1 is at least one selected from the group consisting of calcium ion, magnesium ion, aluminum ion, zinc ion, bismuth ion, manganese ion, sodium ion, potassium ion, and protonated nitrogen base; a is an integer of 1 to 3; m is an integer of 1 to 3; and a = m.

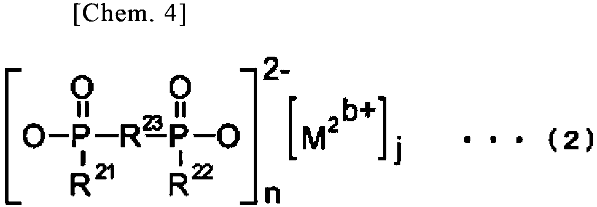

In the above formula (2), R21 and R22 each independently represent a linear or branched alkyl group with 1 to 6 carbon atoms, aryl group, or phenyl group; R23 represents a linear or branched alkylene group with 1 to 10 carbon atoms, arylene group with 6 to 10 carbon atoms, alkyl arylene group with 6 to 10 carbon atoms, or arylalkylene group with 6 to 10 carbon atoms; M2 represents at least one selected from the group consisting of calcium ion, magnesium ion, aluminum ion, zinc ion, bismuth ion, manganese ion, sodium ion, potassium ion, and protonated nitrogen base; b is an integer of 1 to 3; j is 1 or 2; n is an integer of 1 to 3; and b·j = 2n.

The flame retardant (f) is preferably a substantially halogen-free inorganic or organic flame retardant.

As used herein, "substantially halogen-free" refers to a halogen concentration of less than 2 mass% in the resin composition containing the flame retardant (f). In the resin composition containing the flame retardant (f), the halogen concentration is preferably less than 1 mass%, and more preferably less than 0.5 mass%.

The content of the flame retardant (f) may be in the range of 1 to 40 parts by mass per 100 parts by mass of the matrix resin (A). A flame-retardant effect is achieved when the content of the flame retardant (f) is 1 part by mass or more, and the decrease in mechanical strength and heat resistance is reduced when the content is 40 parts by mass or less.

Methods of adding the flame retardant (f) include, for example, the method of adding the flame retardant (f) to each of the dispersed phase resin and the continuous phase resin in the resin composition. Specifically, an exemplary method includes the method of adding, to the resin forming the dispersed phase and the resin forming the continuous phase, one or more flame retardants selected from the group consisting of phosphoric acid esters, nitrogen-containing cyclic compounds, phosphoric acid-based nitrogen-containing compounds, phosphazene-based compounds, boric acid compounds, silicone oils, and phosphinates.

Among these, a preferred method is adding different flame retardants to the dispersed phase and the continuous phase. Specifically, it is desirable to add one or more members selected from the group consisting of phosphoric acid esters, phosphoric acid-based nitrogen-containing compounds, phosphazene-based compounds, and silicone oils, to the dispersed phase, and one or more members selected from the group consisting of nitrogen-containing cyclic compounds, phosphoric acid-based nitrogen-containing compounds, boric acid compounds, and phosphinates, to the continuous phase.

### (Anti-dripping agent)

Additionally, the thermoplastic resin composition may further contain an anti-dripping agent.

Examples of the anti-dripping agent include fluorine-based polymers such as tetrafluoroethylene.

It is preferable that the content of the anti-dripping agent is such that the halogen concentration is less than 2 mass%, when the entire thermoplastic resin composition is considered 100 mass%. In this case, the anti-dripping agent also acts as a flame retardant.

### (Colorant)

Additionally, the thermoplastic resin composition may further contain a colorant.

A method of coloring the thermoplastic resin composition is not particularly limited, and one or more colorants selected from known organic dyes and inorganic pigments can be used.

Examples of the organic pigments include azo pigments such as azo lake pigments, benzimidazolone pigments, diarylide pigments, and condensed azo pigments, phthalocyanine pigments such as phthalocyanine blue and phthalocyanine green, condensed polycyclic pigments such as isoindolinone pigments, quinophthalone pigments, quinacridone pigments, perylene pigments, anthraquinone pigments, perinone pigments, and dioxazine violet, azine pigments, and carbon black.

Among these, it is preferable that the carbon black has a dibutyl phthalate (DBP) absorption amount of less than 250 mL/100 g, and preferably less than 150 mL/100 g, and has a nitrogen adsorption specific surface area of less than 900 m²/g, and more preferably less than 400 m²/g. When they are in the above ranges, a composition having particularly excellent colorability, mechanical strength, and flame retardance can be obtained.

The DBP absorption amount and the nitrogen adsorption specific surface area as used herein refer to values measured with the methods specified in ASTM D2414 and JIS K6217, respectively.

Examples of the azine pigments include Solvent Black 5 (C.I. 50415, CAS No. 11099-03-9), Solvent Black 7 (C.I. 50415: 1, CAS No. 8005-20-5/101357-15-7), and Acid Black 2 (C.I. 50420, CAS No. 8005-03-6/68510-98-5) in the color index.

Examples of the inorganic pigments include metal oxides other than iron oxide, such as zinc oxide and chromium oxide, and composite metal oxides such as titan yellow, cobalt blue, and ultramarine.

The amount of the colorant added is preferably 2 mass% or less for carbon black, 2 mass% or less for azine dyes, and 8 mass% or less for inorganic pigments when the entire resin composition is considered 100 mass%. The amount is more preferably 1 mass% or less for carbon black, 1 mass% or less for azine dyes, and 5 mass% or less for inorganic pigments.

When the colorant is added to the above-described content, it is possible to maintain a good balance between impact resistance and mechanical properties. Further, in a case of an application that requires flame retardancy, the colorant is preferably added in the above-described amount from the viewpoint of flame retardancy.

### (Inorganic filler)

In addition to the above-described components, an inorganic filler may be added to the thermoplastic resin composition at any stage as necessary to the extent that the effects of the present embodiment are impaired.

Examples of the inorganic filler that may be used include fibrous, particulate, plate-like, and needle-like inorganic reinforcing materials such as glass fibers, potassium titanate fibers, gypsum fibers, brass fibers, ceramic fibers, boron whisker fibers, mica, talc, silica, calcium carbonate, kaolin, calcined kaolin, wollastonite, xonotlite, apatite, glass beads, glass flake, and titanium oxide. Two or more of these inorganic fillers can be used in combination. Of these, more preferred inorganic fillers are glass fibers, carbon fibers, and glass beads. Inorganic fillers that have been surface treated in a known manner using a surface treatment agent such as a silane coupling agent may also be used. However, because natural ore-based fillers often contain trace amounts of iron elements, it is necessary to select and use fillers that have been purified to remove iron elements.

The specific amount of each of these inorganic fillers added is preferably 40 mass% or less, more preferably 35 mass% or less, and even more preferably 30 mass% or less, when the entire thermoplastic resin composition is considered 100 mass%.

The preferred amount of the inorganic fillers added in total is preferably 50 mass% or less, more preferably 40 mass% or less, and even more preferably 30% or less, when the entire thermoplastic resin composition is considered 100 mass%.

The inorganic filler may be surface-treated and can use known ones, and fibrous fillers and plate-like fillers are preferred.

Examples of the fibrous filler include, but are not limited to, glass fibers, carbon fibers, whiskers such as potassium titanate whisker, and calcium silicate (wollastonite).

Examples of the plate-like filler include, but are not limited to, glass flake, mica, and talc.

These may be used alone or in combination of two or more of kinds. Among the fillers, glass fibers are most preferable from the viewpoint of rigidity and water resistance.

Examples of the surface treatment to be performed on the inorganic filler include, but are not limited to, surface treatment using various coupling agents such as silane-based and titanate-based ones; in particular, preferred is a surface treatment using a silane-based coupling agent such as aminosilane or epoxysilane, from the viewpoints of improving adhesion between the resin and the inorganic filler subjected to the surface treatment to improve vibration fatigue characteristics and impact resistance of the resin composition. In addition, it is more preferable to use a surface treatment agent containing an acid functional group from the viewpoint of water resistance.

Whether or not an acid functional group is contained can be determined by whether or not an acid-derived peak is detected when the surface treatment agent of the glass fibers is extracted in chloroform and measured by PyGCMS. In particular, it is more preferable to use glass fibers in which a carboxylic acid-derived peak is detected from the viewpoint of water resistance.

Examples of the acid contained in a compound containing the acid functional group include unsaturated carboxylic acid or a derivative thereof, where examples of the unsaturated carboxylic acid include maleic acid, fumaric acid, itaconic acid, acrylic acid, tetrahydrophthalic acid, citraconic acid, crotonic acid, and isocrotonic acid, and examples of a derivative thereof include anhydrides, acid halides, amides, imides, and esters. Specific examples thereof include maleic anhydride, acetic anhydride, succinic anhydride, monomethyl maleate, dimethyl maleate, maleimide, and glycidyl maleate.

The silane-based coupling agent (silane coupling agent) used for the surface treatment is not particularly limited, but it is preferably 3-aminopropyltriethoxysilane, 3-aminopropyltrimethoxysilane, N-2-(aminoethyl)-3-aminopropylmethoxysilane, 3-glycidoxypropyltrimethoxysilane, or 3-glycidoxypropyltriethoxysilane.

Examples of the surface treatment method for the inorganic filler include a method of, in a case where the inorganic filler is glass fiber, applying a silane coupling agent along with a sizing agent to the surface when the fibrous inorganic filler is spun and converged, and then performing drying, and a method of, in a case where the inorganic filler is short fiber or powder, impregnating these fillers with a silane coupling agent solution and then performing drying. The temperature during the drying is preferably 100 °C or higher.

The glass fibers used are obtained by melting spinning glass that is commonly available, such as E-glass (Electrical glass), C-glass (Chemical glass), A-glass (Alkali glass), S-glass (High strength glass), D-glass, R-glass, and alkali-resistant glass. One preferred example of the present embodiment is E glass, and D glass is also preferred for achieving further lower dielectric properties.

The inorganic fibers are preferably low-dielectric inorganic fibers to further lower the dielectric properties of the resin composition, and more preferably low-dielectric glass fibers. Low-dielectric inorganic fibers refer to inorganic fibers with low relative dielectric constant and low dielectric loss tangent, examples of which include inorganic fibers with a relative dielectric constant of 7 or less. The relative dielectric constant herein is a value measured according to ASTM D 150.

Examples of such low-dielectric glass fibers include glass fibers made of 65 to 85 mass% of SiO₂, 15 to 30 mass% of B₂O₃, 0 to 4 mass% of sodium oxide (Na₂O) and/or potassium oxide (K₂O), and 0 to 4 mass% of other components (the total amount here does not exceed 100 mass%, and the total is preferably 100 mass%). Such glass fibers with a high B₂O₃ content are known as low-dielectric glass fibers.

The thermoplastic resin composition may further include talc in an amount of 0.1 to 300.0 parts by mass per 100 parts by mass of the laser direct structuring additive. The inclusion of talc can improve dimensional stability and product appearance and can also increase the plating growth rate. Additionally, the inclusion of talc allows for maintaining the platability of the resin molded product even when the content of the LDS additive is reduced.

Talc that has been surface-treated with at least one compound selected from polyorganohydrogensiloxanes and organopolysiloxanes may also be used. In this case, the amount of the siloxane compound attached to the talc is preferably 0.1 to 5 mass% of the talc.

The number average particle diameter of the talc is preferably 0.1 to 50 µm, more preferably 0.1 to 25 µm. Talc is usually in a flaky form, with the length of the longest part considered as the average particle diameter. The number average particle diameter of talc is measured by randomly selecting talc to be measured from images obtained by observing under an electron microscope and calculating from the obtained measurements. The observation magnification is set at 1,000x, and at least 1,000 particles are measured.

The thermoplastic resin composition may contain only one type of talc or two or more types.

Although materials with low dielectric constants are often preferably used for the component for a telecommunication apparatus of the present embodiment, control on dielectric constant may be required for miniaturization, and materials with high dielectric constants may be needed in some cases. In such cases, the dielectric constant can be controlled by adding an inorganic filler with a high dielectric constant.

Examples include titanium oxide and calcium carbonate. Even when a high dielectric constant is required, the dielectric loss tangent preferably remains low, and materials that increase the dielectric loss tangent due to moisture absorption, etc., will degrade the performance of the antenna.

### (Other components)

In addition to the above-mentioned components, the thermoplastic resin composition may contain, as other additive components, plasticizers (such as low-molecular weight polyolefin, polyethylene glycol, and fatty acid esters), antistatic agents, nucleating agents, fluidity improvers, reinforcing agents, various peroxides, spreading agents, copper-based heat stabilizers, organic heat stabilizers typified by hindered phenol-based oxidative degradation inhibitors, antioxidants, ultraviolet absorbers, light stabilizers, lubricants such as ethylene bisstearate amide, and denaturants such as maleic anhydride.

The specific amount of each of these other components added is preferably 15 mass% or less, more preferably 13 mass% or less, and even more preferably 10 mass% or less when the entire thermoplastic resin composition is considered 100 mass%.

The preferred amount of other components added in total is preferably 30 mass% or less, more preferably 25 mass% or less, and even more preferably 20% or less, when the entire thermoplastic resin composition is considered 100 mass%.

### (Method of producing thermoplastic resin composition)

The thermoplastic resin composition can be produced by melt-kneading the components constituting the (A) component, (B) LDS additive, and colorant, inorganic filler, and other components as necessary.

Examples of melt-kneading machines that can be used to perform the melt-kneading include, but are not limited to, machines that perform heated melt-kneading through a single screw extruder, a multi-screw extruder such as a twin screw extruder, a roll, a kneader, a Brabender Plastograph, a Banbury mixer, or the like. In particular, a twin screw extruder is preferable from a viewpoint of kneadability. Specific examples include the ZSK series manufactured by Werner & Pfleiderer, the TEM series manufactured by Toshiba Machine Co., Ltd., and the TEX series manufactured by The Japan Steel Works, Ltd.

In this process, the melting and kneading temperature that, in the case of a crystalline resin, is at least the melting point of the crystalline resin and, in the case of an amorphous resin, is at least the glass transition temperature of the non-crystalline resin, may be selected such as to enable melt-kneading and processing without difficulty. Normally, the melt-kneading temperature can be arbitrarily selected from 200 °C to 370 °C. Specifically, it is preferable to process at a temperature of 260 °C or higher because this allows for controlling the inter-particle distance by maintaining a certain level of viscosity.

The following describes a preferable production method using an extruder.

The L/D (effective barrel length/barrel internal diameter) of the extruder is preferably 20 or more and 60 or less, and more preferably 30 or more and 50 or less.

Although no specific limitations are placed on the configuration of the extruder, the extruder preferably includes a first raw material feeding inlet at an upstream side relative to the direction of raw material flow, a first vacuum vent downstream to the first raw material feeding inlet, a second raw material feeding inlet downstream to the first vacuum vent (and third and fourth raw material feeding inlets may also be provided downstream to the second raw material feeding inlet as necessary), and a second vacuum vent further downstream to the second raw material feeding inlet. When a liquid addition pump is used, it is further preferable that the liquid addition pump is positioned downstream of the second raw material feeding inlet, and that a second vacuum vent is provided downstream of the liquid addition pump from the viewpoint of achieving flame retardancy. Further, a method of supplying raw materials at the second, third, and fourth raw material feeding inlets is not particularly limited. It may be a method of adding raw materials simply from an upper opening of the raw material feeding inlet, or it may be a method of adding raw materials from a side opening using a forced side feeder. In particular, the method of adding raw materials from a side opening using a forced side feeder is preferable from the viewpoint of stable supply.

In particular, more preferred is an extruder provided with a kneading section upstream to the first vacuum vent, a kneading section between the first vacuum vent and the second material feeding inlet, and a kneading section between the second to fourth material feeding inlets and the second vacuum vent.

Furthermore, the configuration of a screw included in a barrel is not specifically limited and may be a configuration in which right-handed, left-handed, orthogonal (N-type), and back-conveying (L-type) kneading disc elements are provided as appropriate. In particular, a configuration in which at least one orthogonal (N-type) kneading disc element and at least one back-conveying (L-type) kneading disc element are provided between the first raw material feeding inlet and the second raw material feeding inlet, and in which at least one orthogonal (N-type) kneading disc element is provided between the liquid addition pump and the vacuum vent located further downstream than the liquid addition pump is preferable since this configuration enables control of the dispersion state of the (B) LDS additive to within a specific range. Particularly preferable are those containing at least one reverse screw, which allows for controlling the inter-particle distance. However, too many reverse screws lead to over-mixing, which is undesirable. The number of reverse screws is preferably 2 or more, but no more than 5. The reverse screw refers to a screw that rotates in the opposite direction to the feed direction, such as reverse feeding or reverse kneading, regardless of shape.

In a case in which a liquid raw material is to be added, the liquid raw material may be added through direct feeding into the cylinder system using a liquid addition pump or the like, in a cylinder part of the extruder. The liquid addition pump may be, but is not specifically limited to, a gear pump, a flange pump, or the like, for example, and is preferably a gear pump. In this case, from a viewpoint of reducing the load on the liquid addition pump and improving raw material operability, it is preferable to lower the viscosity of the liquid raw material by using a heater or the like to heat a tank for storing the liquid raw material or a section that defines a flow path of the liquid raw material, such as piping between the tank and the liquid addition pump and piping between the pump and the extruder cylinder.

Although no specific limitations are placed on the method by which raw materials are fed at the second to fourth raw material feeding inlets, it is preferable to adopt a method in which raw materials are fed from a side opening of the extruder using a forced side feeder because this tends to enable more stable feeding than when raw materials are simply added through an opening at the second to fourth raw material feeding inlets of the extruder.

In particular, in a situation in which a powder is included among the raw materials and it is desirable to reduce production of crosslinked products or carbides due to resin heat history, a method in which a forced side feeder is used for feeding from the side of the extruder is more preferable, and a method in which forced side feeders are provided at the second to fourth raw material feeding inlets to supply the powder of these raw materials in a divided manner is even more preferable. Specifically, it is preferable to feed the (B) LDS additive from the second to fourth raw material feeding inlets because this allows for controlling the inter-particle distance.

Moreover, in a situation in which a liquid raw material is to be added, it is preferable to adopt a method of adding it into the extruder using a plunger pump, a gear pump, or the like.

Furthermore, the upper openings of the second to fourth material feeding inlets of the extruder can also be used as openings to vent the air contained in the raw materials.

No specific limitations are placed on the melt-kneading temperature and the screw rotation speed in a step of melt-kneading the thermoplastic resin composition. A temperature that, in the case of a crystalline resin, is at least the melting point of the crystalline resin and, in the case of an amorphous resin, is at least the glass transition temperature of the amorphous resin, may be selected such as to enable melt-kneading and processing without difficulty. Normally, the melt-kneading temperature can be freely selected from 200 °C to 370 °C, and the screw rotation speed can be set from 100 rpm to 1,200 rpm.

In one specific aspect of the production method of the thermoplastic resin composition using a twin screw extruder, for example, the components constituting the (A) component and the raw material titanium dioxide are fed to the first material feeding inlet of the twin screw extruder, the heating and melting zone is set to the melting temperature of the thermoplastic resin, and melt-kneading is carried out at a screw rotation speed between 100 and 1200 rpm, preferably between 200 and 500 rpm. The components constituting the (A) component and the raw material titanium dioxide may be fed to the twin screw extruder in batch from the first material feeding inlet of the extruder as described above. Alternatively, the second material feeding inlet, the third material feeding inlet, and the fourth material feeding inlet may be provided to supply each component in a divided manner.

In a situation in which the production of crosslinked products or carbides due to resin heat history in the presence of oxygen is to be reduced, the oxygen concentration in individual process lines of addition paths for raw materials into the extruder is preferably maintained at less than 1.0 volume%. Although these addition paths are not specifically limited, in one specific example of configuration, an addition path comprises, in this order, piping leading from a stock tank, a gravimetric feeder having a refill tank, piping, a feed hopper, and the twin screw extruder. The method by which a low oxygen concentration as described above is maintained is not specifically limited, but a method of introducing an inert gas into individual process lines having increased air tightness is an effective method. In general, it is preferable that nitrogen gas is introduced to maintain an oxygen concentration of less than 1.0 volume%.

In a situation in which the thermoplastic resin in the (A) component includes a component that is in the form of a powder (volume average particle diameter of less than 10 µm), the resin composition production method described above has an effect of reducing residual matter in screws of a twin screw extruder during the production of the resin composition using the twin screw extruder, and also has an effect of reducing the generation of black spot foreign matter, carbides, and the like in the resultant resin composition obtained by the production method described above.

In a specific production method of the thermoplastic resin composition, it is preferable to use an extruder in which the oxygen concentration at each raw material feeding inlet is controlled to be less than 1.0 volume%, and to carry out one of the following methods 1 to 2.
1. A production method involving melt-kneading a part of the components constituting the (A) component to be contained in the resin composition of the present embodiment (first kneading step); and feeding the entire amount of the (B) LDS additive to the molten kneaded product that is obtained through the first kneading step, followed by further melt-kneading (second kneading step).
2. A production method involving melt-kneading a part of the components constituting the (A) component to be contained in the resin composition of the present embodiment (first kneading step), feeding a part of the (B) LDS additive to the molten kneaded material obtained in the first kneading step and melt-kneading (second kneading step); and feeding the remaining amount of the (B) LDS additive, followed by further melt-kneading (third kneading step).

### [Properties of thermoplastic resin composition]

The following describes the properties of a molded article made from the resin composition.

With regards to the Vicat softening temperature of the thermoplastic resin composition constituting the component for a telecommunication apparatus of the present embodiment, a larger value indicates improvement of heat resistance and is preferable.

Note that the Vicat softening temperature refers to a value measured by the method that will be described in EXAMPLES described later.

Heat generation by antenna components for high-frequency applications is high, and the heat generation increases with an increase in the frequency. Thus, having a high heat resistance is demanded. This is particularly required for antenna components operating at frequencies of 1 GHz or higher. From this viewpoint, it is necessary to have a Vicat softening temperature of 90 °C or higher. A higher Vicat softening temperature is more preferred.

With regards to the deflection temperature under load (DTUL) (°C) of the thermoplastic resin composition, a larger value indicates an improvement in heat resistance and is preferable.

Note that the deflection temperature under load (DTUL) refers to a value measured by the methods that will be described in EXAMPLES to be described later.

Heat generation by antenna components for high-frequency applications is high, and the heat generation increases with an increase in the frequency. Thus, a resin with a high heat resistance is demanded.

Particularly, for antenna components operating at frequencies of 1 GHz or higher, the molded article is made from a resin composition with a DTUL of preferably 90 °C or higher, more preferably 92 °C or higher, and particularly preferably 95 °C or higher. A higher heat resistance is more preferred.

In the component for a telecommunication apparatus of the present embodiment, the water absorption rate of the thermoplastic resin composition is 1.5% or less.

In general, components for telecommunication apparatuses such as antennas are often used in open environments, and if they have high water absorption, they will absorb moisture from the atmosphere. In general, when moisture absorption occurs, it leads to a degradation of the dielectric constant, as will be discussed later, resulting in a significant decrease in antenna performance. From this viewpoint, the water absorption rate needs be 1.5% or less, and is preferably 1.0% or less, more preferably 0.5% or less. A smaller water absorption rate is preferred.

A smaller value of the dielectric constant of the molded article that constitutes the component for a telecommunication apparatus of the present embodiment indicates improved antenna performance and is thus preferred.

Note that the dielectric constant refers to a value measured by the method that will be described in EXAMPLES described later.

A smaller value of the dielectric loss tangent of a molded article made from the thermoplastic resin composition indicates a reduced energy loss rate and is thus preferred. Particularly, the dielectric loss tangent is a parameter concerned with moisture absorption, and it is preferable to use a thermoplastic resin composition of which dielectric loss tangent does not increase after being immersed in warm water at 80 °C for 144 hours as an indicator of the characteristics after long-term water absorption. The less the increase in dielectric loss tangent after water immersion, the less likely the material is to absorb moisture in the long term.

Note that the dielectric loss tangent refers to a value measured by the method that will be described in EXAMPLES described later.

In the component for a telecommunication apparatus of the present embodiment, the inter-particle distance of the LDS additive in the thermoplastic resin composition is 2.2 to 3.2 µm. This dispersion state is preferable because it prevents degradation of the dielectric constant and dielectric loss tangent under any molding conditions. It is presumed that maintaining the inter-particle distance within this range prevents the formation of a network of the LDS additive that would degrade dielectric properties even when molding is performed at high temperatures, allowing for excellent antenna characteristics. From a similar viewpoint, the inter-particle distance of the LDS additive is preferably 2.3 to 3.0 µm, more preferably 2.4 to 2.9 µm.

Note that the inter-particle distance refers to a value measured by the method that will be described in EXAMPLES described later.

The inter-particle distance of the LDS additive in the thermoplastic resin composition can be adjusted by adjusting the raw material and adjusting the kneading state in the extruder.

Adjusting the initial particle diameter of the added LDS additive allows for controlling the inter-particle distance. Additionally, the higher the viscosity of the resin component, the easier it is to knead, while the lower the viscosity, the more difficult it becomes to knead. However, it is presumed that controlling the dispersion through the feeding position and screw configuration of the extruder, as discussed later, has a greater effect than the viscosity.

Furthermore, the dispersion state can be controlled depending on whether the LDS additive is added from the upstream, midstream, or downstream in the extruder. Adding it at midstream rather than upstream or downstream rather than midstream tends to shorten the kneading time, resulting in a larger inter-particle distance.

Moreover, the kneading state can be controlled by appropriately setting the screw (especially the kneading section) in the extruder.

Additionally, in the component for a telecommunication apparatus of the present embodiment, the maximum particle diameter of the LDS additive included in the thermoplastic resin composition is preferably 2.2 µm or more, because it becomes easier to achieve the desired inter-particle distance.

Note that the maximum particle diameter of the LDS additive refers to a value measured by the method that will be described in EXAMPLES described later.

Additionally, adjusting the number of particles of the LDS additive observed within the field of view when they are observed makes it easier to achieve the desired inter-particle distance. For example, it is preferable that the number of particles is 250 or less, and more preferably 220 or less in one field of view of 62.02 µm × 39.77 µm when observed under a microscope.

Note that the number of particles of the LDS additive refers to a value measured by the method that will be described in EXAMPLES described later.

### [Molded product and component for telecommunication apparatus]

A molded article constituting the component for a telecommunication apparatus of the present embodiment is made from the above-described thermoplastic resin composition. The method of producing the molded article is not limited, but it can be made by injection molding, for example.

The molded article that is produced by such a method may be used with a coating layer of a paint, metal, other type of polymer, or the like formed on a surface thereof.

The component for a telecommunication apparatus of the present embodiment has one or more of the above molded articles. The component for a telecommunication apparatus may have a structure in which multiple molded articles are mated with each other.

The component for a telecommunication apparatus of the present embodiment has a conductive portion on the surface of the molded article. This conductive portion is conductive and can be formed by applying a metal ink or plating.

The conductive portion may have one or more selected from the group consisting of a metal circuit, metal wiring, and a metal base.

In the component for a telecommunication apparatus of the present embodiment, the conductive portion is formed by laser direct structuring.

The type of plating applied to the molded article is not particularly limited and can include gold, silver, or copper. Furthermore, plating containing multiple metals can be used.

Likewise, metal inks of any metal can be used.

In the component for a telecommunication apparatus of the present embodiment, one of the characteristics is the high copper contamination resistance, which helps reduce cracking after the application of a metal ink or plating.

The laser used is also not specifically defined and can be selected appropriately from known lasers such as YAG lasers, excimer lasers, and electromagnetic radiation. The wavelength of the laser is also not specifically defined.

When the laser is irradiated onto the molded article, only the laser-irradiated portion is activated. With this activated state, the molded article is brought into contact with the plating solution. The plating solution is not particularly defined, and widely known plating solutions can be used. A plating solution (particularly an electroless plating solution) containing one or more of copper, nickel, silver, gold, and palladium is preferred, a plating solution (particularly an electroless plating solution) containing one or more of copper, nickel, silver, and gold is more preferred, and a plating solution (particularly an electroless plating solution) containing copper is even more preferred. In other words, the plating is preferably composed of at least one of the metals mentioned above.

The method of forming the component for a telecommunication apparatus of the present embodiment allows for forming plating (circuit) with a line interval of 1 mm or less, and further 150 µm or less (the lower limit is not specifically defined, but for example, 30 µm or more). To prevent corrosion or degradation of the formed plating (circuit), the plating can be further protected by nickel or gold after electroless plating is performed. Similarly, electrolytic plating can be used after electroless plating to form plating with the required film thickness in a short time.

When a metal ink is applied to the surface of the molded article, various methods can be used to adhere it to the resin. Even methods that require heat resistance, such as method by using laser to achieve adhesion, can be used for the component for a telecommunication apparatus of the present embodiment.

For example, the inkjet method can be used to draw and form circuit patterns on a circuit board using a conductive metal paste on the component for a telecommunication apparatus. This circuit patterning method can rely on known methods (see, for example, JP 2002-324966 A).

The conductive metal paste used is a conductive metal paste prepared by uniformly dispersing ultrafine metal particles having a small average particle diameter in a thermosetting resin composition containing an organic solvent. The ultrafine metal particles with small average particle diameters are selected so that the average particle diameters are in the range of 1 to 100 nm. The surfaces of the ultrafine metal particles are suitably coated with one or more compounds having a group containing a nitrogen, oxygen, or sulfur atom as a group capable of coordinatively bonding with the metal element contained in such ultrafine metal particles.

As the fine metal ultrafine particles having a small average particle diameter to be contained in the conductive metal paste, fine particles consisting of one metal or an alloy consisting of two or more metals selected from the group consisting of gold, silver, copper, platinum, palladium, tungsten, nickel, tantalum, bismuth, lead, indium, tin, zinc, titanium, and aluminum.

The circuit pattern forming method has the steps of spraying or applying the conductive metal paste as minute droplets onto a substrate to draw a circuit pattern of a coated film of the conductive metal paste, and thermally treating the coated film of the drawn conductive metal paste at a temperature equal to or higher than the thermosetting temperature of the thermosetting resin.

Inkjet drawing methods include thermal drawing methods by generating bubbles by heating and ejecting droplets, and piezoelectric drawing methods by ejecting droplets by compression using a piezoelectric element.

The component for a telecommunication apparatus of the present embodiment can be used in various applications, such as electronic components including sensors, connectors, switches, relays, conductive circuits, and antennas (particularly components of portable electronic devices, communication base stations, and personal computer peripherals).

### EXAMPLES

The following provides a more detailed description of the present embodiment through examples and comparative examples. However, the present embodiment is not limited to the following examples.

Raw materials used in the examples and comparative examples were as follows.

### [Raw materials]

(A-1) Polyphenylene ether
(A-a-1) Polyphenylene ether resin obtained by oxidative polymerization of 2,6-xylenol
   The reduced viscosity (measured with 0.5 g/dL chloroform solution at 30 °C) of the polyphenylene ether resin (A-a-1) was 0.52 dL/g.
(A-a-2) Polyphenylene ether resin obtained by oxidative polymerization of 2,6-xylenol
   The reduced viscosity (measured with 0.5 g/dL chloroform solution at 30 °C) of the polyphenylene ether resin (A-a-2) was 0.40 dL/g.
(A-a-3) Polyphenylene ether resin obtained by oxidative polymerization of 2,6-xylenol
   The reduced viscosity (measured with 0.5 g/dL chloroform solution at 30 °C) of the polyphenylene ether resin (A-a-3) was 0.32 dL/g.

### (B) LDS additive

(B-1) Tin oxide doped with antimony (product name: "StanoStat CP05", manufactured by Keeling & Walker Limited; average particle diameter: 1.25 µm)
(B-2) Tin oxide doped with antimony (product name: "Iriotec 8815", manufactured by Merck; average particle diameter: 0.45 µm)
(B-3) Copper chromite (product name: "LD14", manufactured by Shepherd Color Company; average particle diameter: 0.65 µm)
(B-4) Copper chromite (product name: "SPP-3089", manufactured by Vibrantz Technology; average particle diameter: 1.40 µm)

The particle diameter of each LDS additive was measured as follows: after an epoxy resin in which the LDS additive particles were dispersed was cured, it was dissected with a microtome. A cross-section was observed for the measurement.

The morphology of the sample was observed using SEM-EDX. The SEM used was SU-8220 (Hitachi High-Tech), and the EDX used was Quantax SYSTEM (Bruker).

The imaging conditions were as follows: the acceleration voltage was 1.5 kV and the image capturing mode was the composition (LA) image for capturing SEM images, and the acceleration voltage was 10 kV and the analysis mode was the mapping analysis for EDX measurements.

The magnification was set to 5,000x (for capturing SEM images) and 2,000x or 5,000x (for EDX mapping measurements).

Image analysis was performed using these images to measure the average particle diameter of the LDS additive.

The conditions for image analysis involved binarizing the images obtained from Cr and Sn mapping obtained by EDX mapping measurements (taken at an imaging magnification of 2,000x or 5,000x) using image processing software, and measuring the particle diameter, inter-particle distance, and number of particles extracted. The field of view was 62.02 × 39.77 (µm) for images at a magnification of 2,000x or 24.81 × 15.91 (µm) for images at a magnification of 5,000x, with n=1 for each field of view, and image analysis was performed with n=2 or more. The software used was ImageJ 1.52a.

Particles with an area of less than 0.03 µm² at a magnification of 2,000x or less than 0.01 µm² at a magnification of 5,000x were excluded as they could not be distinguished from disturbance factors. Additionally, particles crossing the boundaries of the field of view were excluded. The particle diameter was measured by converting the area of each particle to an equivalent circle diameter.

(A-b) Block copolymer containing at least one block mainly composed of aromatic vinyl monomer unit and at least one block mainly composed of conjugated diene monomer unit, and/or hydrogenated product of the block copolymer

Hydrogenated block copolymer (product name: "TUFTEC^{®} H1051", manufactured by Asahi Kasei Corporation) (TUFTEC is a registered trademark in Japan, other countries, or both)

### (A-c) Polystyrene-based resin

(A-c-1) Polystyrene (product name: "GPPS 685", manufactured by PS Japan Corporation)
(A-c-2) High impact polystyrene (product name: "CT-60", manufactured by Petrochemicals Corporation)

### (A-d) Polyamide 6,6 (hereinafter referred to as PA66)

In a 5-liter autoclave, 2400 g of an equimolar salt of adipic acid and hexamethylenediamine, 100 g of adipic acid, and 2.5 liters of pure water were charged and stirred sufficiently. After the atmosphere in the autoclave was sufficiently replaced with nitrogen, the temperature was raised from room temperature to 220 °C under stirring for about 1 hour. In this step, the gauge pressure in the autoclave reached 1.76 MPa at the natural pressure of water vapor. Subsequently, heating was continued while water was removed from the reaction system such that the pressure was prevented from reaching 1.76 MPa or higher. After another 2 hours, when the internal temperature reached 260 °C, the autoclave was depressurized by opening and closing the autoclave valve for about 40 minutes until the internal pressure dropped to 0.2 MPa while heating was continued. The reactant was then allowed to cool to room temperature over about 8 hours. After cooling, the autoclave was opened and about 2 kg of a polymer was removed and ground.

The polyamide obtained had an Mw of 38,700 and an Mw/Mn of 2.1. Note that Mw and Mn were determined using GPC (mobile layer: hexafluoroisopropanol, standard: PMMA (polymethyl methacrylate)).

The end amino group concentration was measured according to the method for measuring the end amino group concentration described in EXAMPLES in JP H7-228689 A, and was determined to be 38 µmol/g.

### (A-e) Polypropylene homopolymer with MFR = 2 g/10 min

### (A-f) Polyethylene resin

(A-f-1) High-density polyethylene resin ("Suntec-HD B161", manufactured by Asahi Kasei Corporation)
(A-f-2) High-density polyethylene resin ("Suntec-HD J320", manufactured by Asahi Kasei Corporation)

### (C-E) Other components

(C) Ethylenebis stearate amide: "KAO WAX EB-G", manufactured by Kao Corporation
(D) Maleic anhydride ("Crystal MAN", manufactured by NOF CORPORATION
(E) Calcium carbonate (SL-2200 manufactured by Takehara Kagaku Kogyo Co., Ltd.)

### (MF) Inorganic filler

(MF-1) Glass fibers (ECS03-T249 manufactured by NEG Co., Ltd.)
(MF-2) Glass flake (MEG160FY M06 manufactured by Nippon Sheet Glass Co., Ltd.)
(MF-3) Talc ("Crown Talc PK-MMB", manufactured by Matsumura Sangyo Co., Ltd.)

### (FR) Flame retardant

(FR-1) Product name: E890, manufactured by Daihachi Chemical Industry Co., Ltd.
(FR-2) Product name: PX-200, manufactured by Daihachi Chemical Industry Co., Ltd.

### [Examples 1 to 14 and Comparative Examples 1 to 12]

A resin composition was produced by blending components in the compositions summarized in Tables 1 and 2, using a twin-screw extruder ZSK-40 (manufactured by Coperion Werner & Pfleider, Germany). This twin screw extruder was provided with a first material feeding inlet provided upstream to the flow direction of the material, a first vacuum vent provided downstream to the first material feeding inlet, a second material feeding inlet provided downstream to the first vacuum vent, a third material feeding inlet provided downstream to the second material feeding inlet, and a second vent provided downstream to the third material feeding inlet. An additional liquid addition pump and/or vacuum vent were provided further downstream than the first raw material feeding inlet as necessary, and the positions thereof were appropriately changed as necessary.

Here, four kneading sections were provided: one between the first feeding inlet and the first vacuum vent, one between the first vacuum vent and the second feeding inlet, one between the second feeding inlet and the third feeding inlet, and one between the third feeding inlet and the second vacuum vent. In each of these four kneading sections, back-conveying (L-type) kneading disc elements were provided in the number specified in the table.

Using the extruder configured as described above, each component was added in the composition and addition method summarized in Tables 1 and 2, and molten and kneaded under the conditions of an extrusion temperature from 250 to 320 °C, a screw rotation speed of 300 rpm, and a discharge rate of 100 kg/hour to produce pellets.

### [Evaluation methods]

Samples obtained in the examples and comparative examples were used to perform the following evaluations. Evaluation results are summarized in Tables 1 and 2.

### (1) Dielectric constant and dielectric loss tangent

Produced resin composition pellets were fed into a small-sized injection molding machine (product name: EC75-SXII manufactured by Toshiba Machine Co., Ltd.), of which the cylinder temperature was set to 250 to 290 °C, and were molded under conditions of a mold temperature of 70 to 130 °C, an injection pressure of 200 MPa, an injection time of 10 seconds, and a cooling time of 20 seconds to produce a flat plate of 60 mm × 60 mm × 0.9 mm. The dielectric constant and dielectric loss tangent at 2.5 GHz were measured under the following conditions.
Measurement frequency: 2.5 GHz
Measurement apparatus: PNA Network Analyzer N5224B for 10 MHz to 43.5 GHz, Split Post Dielectric Resonator N1501AE10 for 10 GHz
Environmental conditions for measurement: room temperature of 23 °C and humidity of 50%.

### (2) Dielectric loss tangent when molding was carried out at high temperature

Produced resin composition pellets were fed into a small-sized injection molding machine (product name: EC75-SXII manufactured by Toshiba Machine Co., Ltd.), of which the cylinder temperature was set to 340 °C, and were molded under conditions of a mold temperature of 70 to 130 °C, an injection pressure of 200 MPa, an injection time of 10 seconds, and a cooling time of 20 seconds to produce a flat plate of 60 mm × 60 mm × 0.9 mm. The dielectric loss tangent at 2.5 GHz was measured under the same conditions as in (1).

### (3) Dielectric loss tangent upon water absorption

Produced resin composition pellets were fed into a small-sized injection molding machine (product name: EC75-SXII manufactured by Toshiba Machine Co., Ltd.), of which the cylinder temperature was set to 340 °C, and were molded under conditions of a mold temperature of 70 to 130 °C, an injection pressure of 200 MPa, an injection time of 20 seconds, and a cooling time of 20 seconds to produce a flat plate of 60 mm × 60 mm × 0.9 mm. After the flat plate was immersed in warm water at 80 °C for 144 hours, the dielectric loss tangent at 2.5 GHz was measured under the same conditions as in (1).

### (4) Heat resistance

### (4-1) Vicat softening temperature

Produced resin composition pellets were fed into a small-sized injection molding machine (product name: EC75-SXII manufactured by Toshiba Machine Co., Ltd.), of which the cylinder temperature was set to 340 °C, and were molded under conditions of a mold temperature of 70 to 130 °C, an injection pressure of 200 MPa, an injection time of 10 seconds, and a cooling time of 20 seconds to produce a flat plate of 60 mm × 60 mm × 0.9 mm. The measurements were conducted using test specimens cut to arbitrary sizes, under the following conditions: test load of 50 N, using a cylindrical indenter tip shape with a cross-sectional area of 1 mm², heating rate of 50 °C/hr, and a measurement number n=2.

As an evaluation criterion, it was judged that the heat resistance was better and the material was thus advantageous for material design in this application as the Vicat softening temperature was higher.

### (4-2) Deflection temperature under load (DTUL)

Produced resin composition pellets were fed into a small-sized injection molding machine (product name: EC75-SXII manufactured by Toshiba Machine Co., Ltd.), of which the cylinder temperature was set to 250 to 350 °C, and were molded under conditions of a mold temperature of 70 to 130 °C, an injection pressure of 200 MPa, an injection time of 20 seconds, and a cooling time of 15 seconds to prepare an ISO dumbbell for evaluation. This ISO dumbbell was then cut to produce a test piece for deflection temperature under load (DTUL) measurement. The deflection temperature under load: DTUL (ISO 75: under a load of 1.80 MPa) was measured using this test piece for deflection temperature under load measurement.

A larger value was judged to indicate better heat resistance.

### (5) Morphology

### (5-1) Maximum particle diameter

### (5-2) Inter-particle distance

### (5-3) Number of particles

After the central part of an ISO dumbbell molded under the same conditions as described in (4) described above was cut out, the surrounding area was trimmed corresponding to the observation target position and direction (MD direction), and a frozen-cut cross-section was prepared by trimming and using a cryomicrotome. Then, the sample was stained with RuO₄, fixed to the SEM sample stage, and subjected to conductive treatment before being used as a sample for microscopy.

The morphology of the microscopy sample was observed using SEM-EDX. SEM used was SU-8220 (Hitachi High-Tech), and EDX used was Quantax SYSTEM (Bruker).

The imaging conditions were as follows: the acceleration voltage was 1.5 kV and the image capturing mode was the composition (LA) image for capturing SEM images, and the acceleration voltage was 10 kV and the analysis mode was the mapping analysis for EDX measurements.

The magnification was set to 5,000x (for capturing SEM images) and 2,000x or 5,000x (for EDX mapping measurements).

Image analyses were conducted using these images to measure (5-2) the inter-particle distance, (5-1) the maximum particle diameter, and (5-3) the number of particles, of the LDS additive.

The conditions for image analysis involved binarizing the images obtained from Cr and Sn mapping obtained by EDX mapping measurements (taken at an imaging magnification of 2,000x) using image processing software, and measuring the particle diameter, inter-particle distance, and number of particles of particles sampled. If the particles were small and the number of particles observed in one image was 1,000 or more, the magnification was increased to 5,000x. The number of particles was multiplied by 6.25 to match the value at a magnification of 2,000x. The field of view was 62.02 × 39.77 (µm) for images at a magnification of 2,000x or 24.81 × 15.91 (µm) for images at a magnification of 5,000x, with n=1 for each field of view, and image analysis was performed with n=2 or more. The software used was ImageJ 1.52a. Particles with an area of less than 0.03 µm² at a magnification of 2,000x or less than 0.01 µm² at a magnification of 5,000x were excluded as they could not be distinguished from disturbance factors. Particles crossing the boundaries of the field of view were excluded. The particle diameter was measured by converting the area of each particle to an equivalent circle diameter. The average inter-particle distance was calculated as {the sum of (each distance interval × frequency) / the sum of frequency}. The inter-particle distance was calculated based on the shortest distance between the centers of gravities of the particles.

### (6) Antenna performance when molding was performed at high temperature

Simulation of antenna efficiency was performed under the following conditions.
- Antenna substrate: 60 × 7 × 1 mm³, fully plated GND, pattern width: 1 mm, and thickness: 25 µm
- Copper + Ni plating
- Main substrate: 60 × 130 × 1 mm³, relative dielectric constant: 4.0, dielectric loss: 0.020, thickness: 35 µm, conductivity: 5.8 × 10⁷ S/m
- Simulation apparatus: MW STUDIO from CST

The reflection coefficient was adjusted to be 6 dB or less in the operating frequency band.

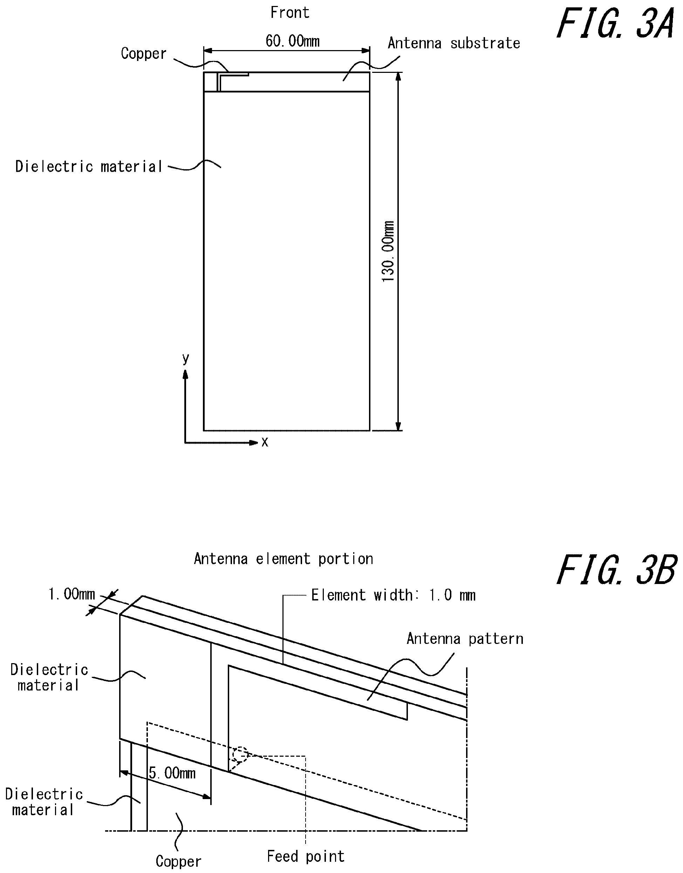

The antenna element length and matching circuit values were adjusted to achieve the best matching at 3.5 GHz, and the antenna efficiency at that time was calculated. The shape and dimensions of the antenna used are illustrated in FIG. 3. FIG. 3(a) illustrates the overall shape of the antenna, and FIG. 3(b) illustrates an enlarged view of the antenna element portion.

The dielectric properties (dielectric constant and dielectric loss tangent) of the material were measured as follows. Produced resin composition pellets were fed into a small-sized injection molding machine (product name: EC75-SXII manufactured by Toshiba Machine Co., Ltd.), of which the cylinder temperature was set to 340 °C, and were molded under conditions of a mold temperature of 70 to 130 °C, an injection pressure of 200 MPa, an injection time of 20 seconds, and a cooling time of 20 seconds to produce a flat plate of 60 mm × 60 mm × 0.9 mm. The dielectric loss tangent at 5 GHz was measured under the following conditions.
- Measurement frequency: 5 GHz
- Measurement apparatus: PNA Network Analyzer N5224B for 10 MHz to 43.5 GHz, Split Post Dielectric Resonator N1501AE10 for 5.2 GHz
- Environmental conditions for measurement: room temperature of 23 °C and humidity of 50%.

The antenna performance was better as the value was closer to 0. The simulation was conducted assuming that the antenna would function even if the material was difficult to plate because platability was not considered in this simulation.

### (7) LDS platability

Produced resin composition pellets were fed into a small-sized injection molding machine (product name: EC75-SXII manufactured by Toshiba Machine Co., Ltd.), of which the cylinder temperature was set to 280 to 320 °C, and were molded under conditions of a mold temperature of 80 °C, an injection pressure of 100 MPa, an injection time of 15 seconds, and a cooling time of 20 seconds to produce a flat plate of 60 mm × 60 mm × 2.0 mm. A flat plate was activated using a laser irradiation machine (product name: "Micro Line 3D160", manufactured by LPKF Inc.), and then plating was applied using an electroless copper plating bath (product name: "MID copper 100B1", manufactured by McDermid) under the plating conditions of 57 °C for 45 minutes. Plating performance was visually evaluated based on the thickness of the copper plating using the following criteria. In addition, the adhesion of the plating was evaluated by making a cross-cut on the plating with a cutter, applying CELLOTAPE tape, and peeling it off. Plating that adhered to the CELLOTAPE tape and peeled off was evaluated as having poor adhesion.
O (Good): The plating adhered well, and the adhesion of the plating was good
X (Poor): The plating did not adhere at all, or only partially adhered, and the adhesion of the plating was not good

### (8) Water absorption rate

Produced resin composition pellets were fed into a small-sized injection molding machine (product name: EC75-SXII manufactured by Toshiba Machine Co., Ltd.), of which the cylinder temperature was set to 280 to 320 °C, and were molded under conditions of a mold temperature of 80 °C, an injection pressure of 100 MPa, an injection time of 15 seconds, and a cooling time of 20 seconds to produce a flat plate of 60 mm × 60 mm × 2.0 mm. The molded test pieces were immersed in pure water at 23 °C for 24 hours, and the change in weight after immersion was evaluated as the water absorption rate (%). A material with a lower water absorption rate was considered better.

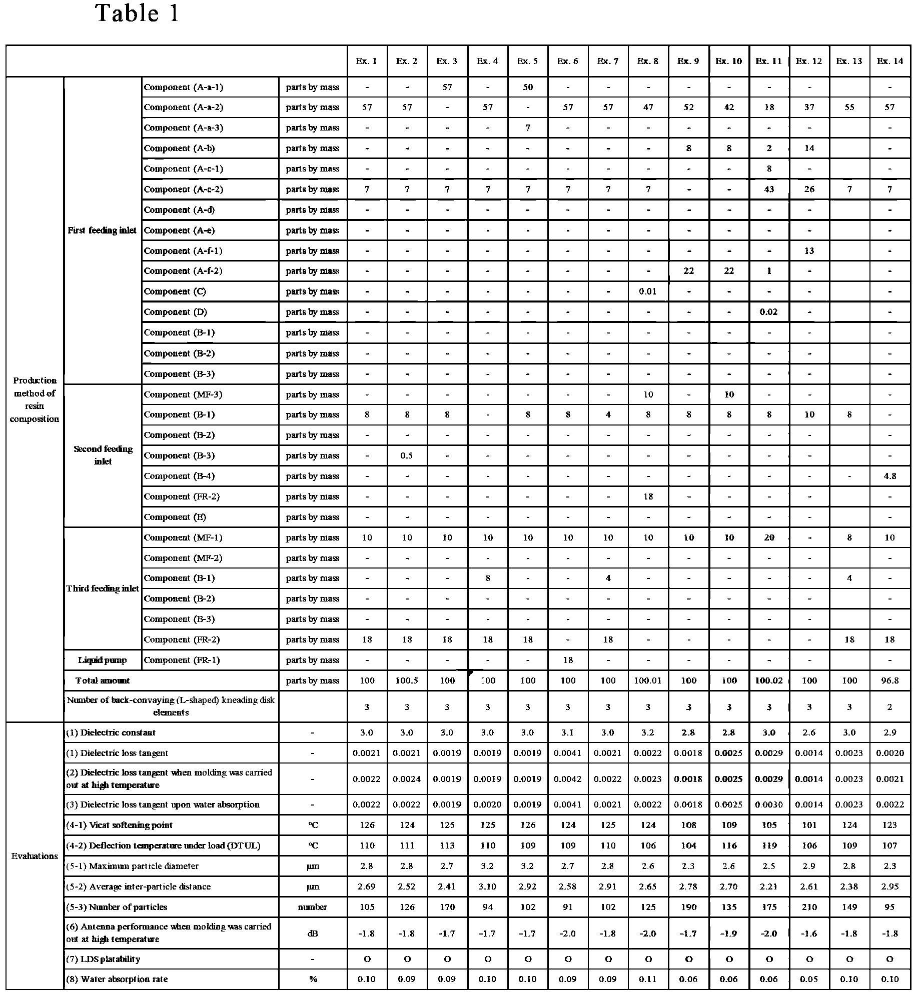

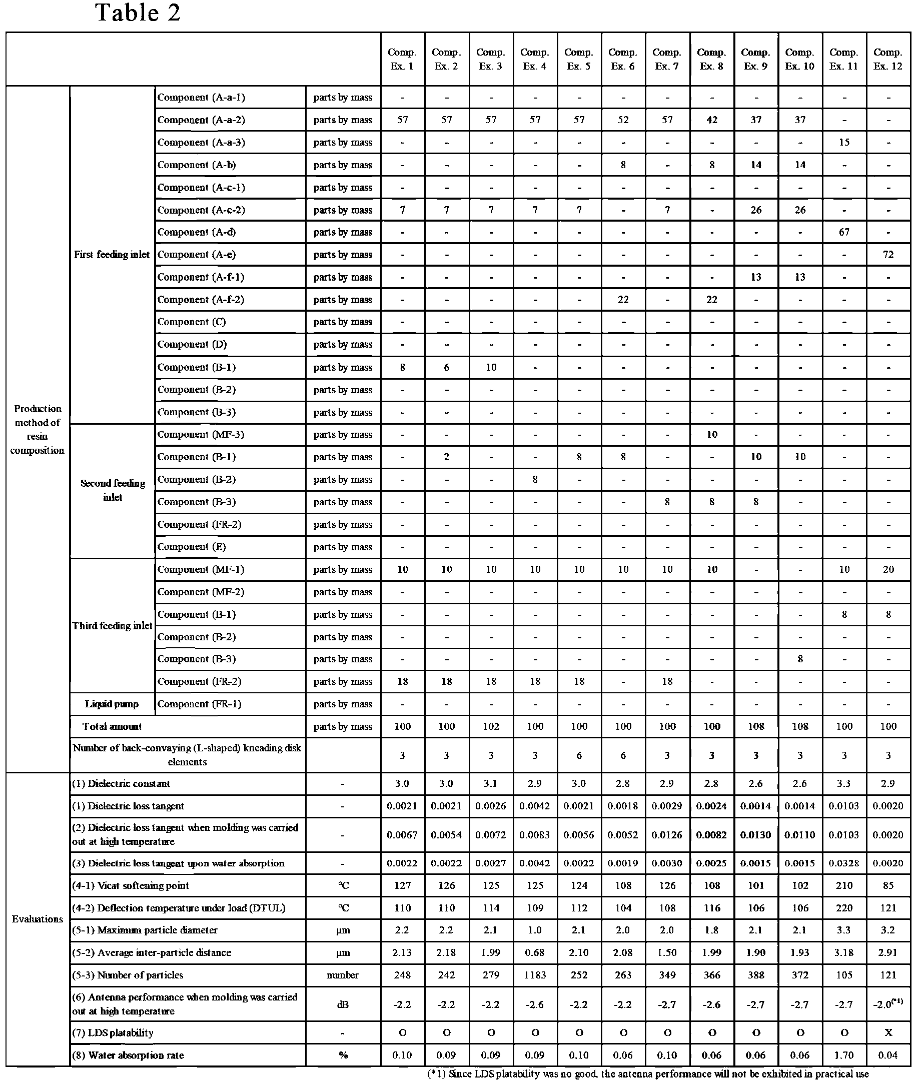

### INDUSTRIAL APPLICABILITY

The thermoplastic resin composition and molded article of the present disclosure can be used as components for telecommunication apparatuses in various applications such as sensors, connectors, switches, relays, conductive circuits, and antennas (particularly components for portable electronic devices, communication base stations, and personal computer peripherals). In particular, they can exhibit high antenna performance in small components regardless of molding conditions and are thus suitable for use.

## Claims

1. A thermoplastic resin composition comprising:
a polyphenylene ether-based resin and a laser direct structuring additive (LDS additive),
wherein an inter-particle distance of the LDS additive is 2.2 to 3.2 µm, and
the thermoplastic resin composition has a Vicat softening temperature of 90 °C or higher and a water absorption rate of 1.5% or less.

2. A molded article made from a thermoplastic resin composition and comprising a conductive portion formed on a surface thereof,
wherein the thermoplastic resin composition comprises a polyphenylene ether-based resin and a laser direct structuring additive (LDS additive),
an inter-particle distance of the LDS additive in the thermoplastic resin composition is 2.2 to 3.2 µm, and
the thermoplastic resin composition has a Vicat softening temperature of 90 °C or higher and a water absorption rate of 1.5% or less.

3. The molded article according to claim 2, wherein the conductive portion is formed by laser direct structuring.

4. A component for a telecommunication apparatus comprising the molded article according to claim 2 or 3.

5. The component for a telecommunication apparatus according to claim 4, wherein the LDS additive is a compound containing antimony and tin.

6. The component for a telecommunication apparatus according to claim 4, wherein the LDS additive presents in 220 particles or fewer in one field of view (62.02 µm × 39.77 µm) when the thermoplastic resin composition is observed under a microscope.

7. The component for a telecommunication apparatus according to claim 4, wherein a maximum particle diameter of the LDS additive is 2.2 µm or more.

8. The component for a telecommunication apparatus according to claim 4, wherein a content of a copper chromate compound as the LDS additive is less than 5 parts by mass per 100 parts by mass of the thermoplastic resin composition.

9. The component for a telecommunication apparatus according to claim 4, wherein a content of the LDS additive is 3 parts by mass or more and less than 20 parts by mass per 100 parts by mass of the thermoplastic resin composition.

10. The component for a telecommunication apparatus according to claim 4, wherein the thermoplastic resin composition contains a block copolymer containing at least one block mainly composed of an aromatic vinyl monomer unit and at least one block mainly composed of a conjugated diene monomer unit, and/or a hydrogenated product of the block copolymer.

11. The component for a telecommunication apparatus according to claim 4, wherein the thermoplastic resin composition has a deflection temperature under load (DTUL) of 90 °C or higher.

12. The component for a telecommunication apparatus according to claim 4, wherein the thermoplastic resin composition has a dielectric constant of 3.0 or less and a dielectric loss tangent of 0.008 or less.

13. The component for a telecommunication apparatus according to claim 4, wherein the dielectric loss tangent after the thermoplastic resin composition is immersed in warm water at 80 °C for 144 hours is 0.03 or less.

14. The component for a telecommunication apparatus according to claim 4, being a component for an antenna.
